# EUROPEAN PATENT SPECIFICATION

(11) **EP 3 791 699 B1**
(45) Date of publication and mention of the grant of the patent: **19.07.2023**
(21) Application number: 18918270.2
(22) Date of filing: 08.05.2018
(51) Int. Cl.: H05K 1/02, H05K 1/09, C09D 11/10, C09D 5/24, C09D 11/52, C09D 183/04, H05K 1/03, C08G 77/12, C08G 77/16, C08G 77/18, C08G 77/20

(54) **METHOD FOR FORMING A FLEXIBLE PRINTED CIRCUIT BOARD**
VERFAHREN ZUR HERSTELLUNG EINER FLEXIBLEN LEITERPLATTE
PROCÉDÉ DE FABRICATION D'UNE CARTE DE CIRCUIT IMPRIMÉ SOUPLE

(43) Date of publication of application: 17.03.2021
(73) Proprietor: Jabil, Inc., St. Petersburg, FL 33716 (US); Che Ani, Fakhrozi, Penang, 11900 (MY); Samsudin, Zambri, Penang, 11900 (MY); Tura Ali, Mohd Yusuf, Penang, 11900 (MY); Ahmad, Zulkifli, Penang, 14300 (MY)
(72) Inventor: CHE ANI, Fakhrozi, Penang, 11900 (MY); SAMSUDIN, Zambri, Penang, 11900 (MY); TURA ALI, Mohd Yusuf, Penang, 11900 (MY); AHMAD, Zulkifli, Penang, 14300 (MY)
(74) Representative: Gulde & Partner
(86) International application number: PCT/MY2018/050029
(87) International publication number: WO 2019/216756

(56) References cited:
- EP-A1- 1 278 211
- EP-A1- 2 582 289
- US-A1- 2010 116 527
- US-A1- 2013 338 746
- US-A1- 2015 322 276
- US-A1- 2016 249 460
- US-A1- 2016 366 760
- US-A1- 2017 086 301
- US-A1- 2017 130 084

## Description

### FIELD OF INVENTION

The field of invention is printed circuit board and more particularly relates to flexible printed circuit boards.

### BACKGROUND

Printed circuits are popularly used in fabrication of sensors, actuators, radio-frequency identification (RFID), health care devices, and display panel. In these applications, it is crucial for the printed circuit to be flexible and stretchable. The printed circuits are composed of two primary components, namely a substrate and the conductive ink.

However, there are intrinsic problems with the stretchable conductive circuit packages. Specifically, the adhesion of the conductive ink to the substrate, the compatibility of elastic modulus between the ink and substrate phases, as well as the inhomogeneity of conductive filler in the ink matrix, are intrinsic problems with the stretchable conductive circuit packages known in the art.

Adhesion between the ink and the substrate is critically important in a flexible printed circuit package. In a flexible printed circuit package, the adhesion between the ink and the substrate needs to be sufficiently strong so as no peeling occurs during stretching or deformation. In addition, the elastic modulus between the conductive ink and the underlying substrate needs to be compatible so that during stretching, both the conductive ink and the underlying substrate stretch at the same rate. Further, the dispersion of conductive filler in the conductive matrix needs to be homogeneous, thus establishing an efficient conductivity pathway.

Documents US 2013/338746 A1, EP 2 582 289 A1, and US 2010/116527 A1 disclose methods wherein both the substrate and the conductive ink comprise polysiloxane. Document EP 1 278 211 A1 discloses that both addition reaction type (cure through hydrosilylation) and condensation cure type organopolysiloxane polymers are suitable for formulating a conductive composition.

The dual curing mechanism of the present invention alleviates the aforementioned drawbacks during development of the conductive circuit.

### SUMMARY

Embodiments of the present invention utilize both an addition mechanism and a condensation mechanism performed simultaneously to form a stretchable conductive ink for a circuit package. When the stretchable conductive ink is used in the circuit package, the circuit package has high reliability and durability.

The invention is defined by the appended claims. The description that follows is subjected to this limitation. Any disclosure lying outside the scope of said claims is only intended for illustrative as well as comparative purposes.

The stretchable conductive circuit package includes a conductive ink and a substrate that have a similar flexibility modulus. If the elastic moduli of either the conductive ink or the substrate is higher than the other, then this will result in local rupture while both remain adhered strongly to each other during strain. Embodiments of the present invention are able to produce a conductive ink and a substrate package with similar flexibility moduli by forming the conductive ink and the substrate from the same material type.

The homogeneity between the conductive filler and the binder used in the conductive ink of the stretchable conductive circuit packages further increases the reliability and durability of the stretchable conductive circuit packages. However, the effect of blooming as well as settling of these particles to the lower level disrupts particulate distribution and homogeneity. These effects are particularly severe in the case of isotropic particulate. The inhomogeneity of the conductive filler and the binder will eventually deteriorate conductivity of the electrical circuit and cause the stretchable conductive circuit packages to fail. Embodiments of the present invention are able to produce a homogenous conductive ink by designing an optimized crosslink network in terms of density and network juxta positioning such that the particles are embedded and become immobilized in the network.

Other embodiments include formulations designed to fabricate a polysiloxane-based conductive ink package utilizing dual mechanism of addition and condensation curing. These formulations may include formulations for both components involved in a condensation reaction, namely Polydimethylsiloxane (PDMS) bearing hydroxyl end group as well as addition curing involving vinyl terminated and organohydrogensiloxane PDMS. These formulations may also include respective catalysts systems. Other formulations may include adhesion promoters and plasticizers that may be used to affect efficient curing.

In addition, in many embodiments, the substrate and the conductive ink may be formed of similar base materials. By virtue of similar types of base materials, the matrix of conductive ink is able to adhere strongly onto the substrate. The interlayer bonding is promoted by the formation of hydrogen bond, polar interaction and van Der Waal forces.

Embodiments also relate to methods of curing protocols and printing of the conductive ink onto the substrate.

### BRIEF DESCRIPTION OF THE DRAWING(S)

Figure 1 is a diagram of a stretchable conductive circuit package.
Figure 2A is a diagram of the addition mechanism.
Figure 2B is a diagram of the condensation mechanism.
Figure 3 is a process map of a process to make a stretchable conductive circuit package.
Figure 4A is a graph of an example Fourier-transform infrared spectroscopy (FTIR) of a substrate of a stretchable conductive circuit package.
Figure 4B is a graph of an example Fourier-transform infrared spectroscopy (FTIR) of a conductive ink of a stretchable conductive circuit package.
Figure 5A is a graph of volume resistivity as a function of applied strain of a stretchable conductive circuit package.
Figure 5B is a graph of resistivity as a function of strain cycle number.

### DETAILED DESCRIPTION OF THE PREFERRED EMBODIMENT

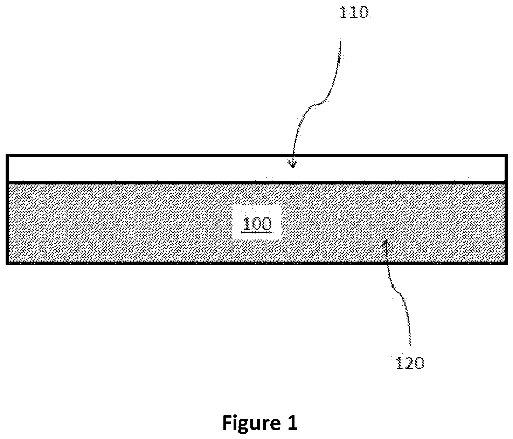

Figure 1 depicts a stretchable conductive circuit package 100. The stretchable conductive circuit package 100 includes a conductive ink 110 and an electrically insulating polymer substrate 120. The polymer substrate 120 and the conductive ink 110 may be equally stretchable so as to be confocal to any surface architecture. In some embodiments, the thickness variation of the polymer substrate is within the range 0.1 mm - 2 mm depending on application.

Polysiloxane may be utilized to fabricate both the polymer substrate 120 and the conductive ink 110 of the stretchable conductive circuit package 100. Polysiloxane may be utilized because of its desirable elastic modulus, stretchability and high thermal stability. In addition, Polysiloxane is transparent which may be desirable in certain applications. For both the conductive ink and the substrate, the basic polysiloxane material may be a hydroxyl or alkoxyl terminated PDMS with dibutyltin dilaurate as catalyst.

The alkoxy terminated PDMS may include any group, other than hydroxyl, (including methoxy, ethoxy, propoxy etc.) provided the other group is hydrolyzable to provide, in situ, a reactive group (e.g., reactive hydrogen). This reactive group is utilized in the condensation reaction.

The functional groups of alkoxy terminated PDMS, in addition to the hydroxyl group (by hydrolysis) may form three-dimensional or cross-linked structures. These structures allow entrapment of conductive filler so as to induce homogeneity and improve thermal and mechanical properties of the resulting material.

In one embodiment, the molecular weight Mn of linear chain hydroxyl terminated PDMS is in the range of 10000 -150000 g/mol, preferably in the range of 50000 - 80000 g/mol. In one embodiment of the substrate formulation, the weight percent of hydroxyl terminated PDMS is in the range of 50% to 95%, more preferably in the range of 80% to 95% or yet more preferably in the range of 90% to 95% based on total weight of the mass of the formulation. In the case of ink formulation, in one embodiment, the weight percent of hydroxyl terminated PDMS is in the range of 5% to 30%, more preferably in the range 11% based on total weight of the mass of the formulation.

For substrate formulation, in one embodiment, fume silica as reinforcing agent having surface area of 300 square meter per gram is added in the range of 3% to 10 %, more preferably in the range of 3% to 5% on total mass of the formulation.

For ink formulation, a liquid triorganosiloxy PDMS and liquid organohydrogensiloxane terminated PDMS is added:

In one embodiment, the triorganosiloxy groups are vinyldimethylsiloxy or vinylmethylphenylsiloxy. In one embodiment, at least 95% of the diorganosiloxane groups are dimethylsiloxane.

The liquid organohydrogensiloxane is in an amount sufficient to provide a silicon-bonded hydrogen atoms per vinyl group present in vinyl terminated PDMS components, said organohydrogensiloxane having an average of at least a silicon-bonded hydrogen atoms per molecule and consisting essentially of units selected from the group consisting of methylhydrogensiloxy, dimethylsiloxy, dimethylhydrogensiloxy and trimethylsiloxy.

For ink formulation, metal catalyst is added. Examples of the catalyst include platinum and rhodium catalyst. Other multivalent metals may be used that are able to form many coordinate bonds with the substrates and, therefore, assist in catalyzing the reaction.

In one embodiment of the invention, the weight percent of the platinum catalyst range from 0.1 ppm to 50 ppm, preferably from 0.1 ppm 10 ppm on total mass of the formulation. The platinum catalyst can be present in an amount sufficient to provide at least one part by weight of platinum for every one million parts by weight of triorganosiloxy PDMS component. In some embodiments, it is preferred to use sufficient catalyst so that there is present from 5 to 50 parts by weight platinum for every one million parts by weight of component triorganosiloxy PDMS component. Although amounts of platinum greater than 50 parts per million are also effective, those amounts are unnecessary and wasteful, especially when the preferred catalyst is used.

For conductive ink formulation, filler is added to encompass materials in which the components are electrically conductive materials suspended and/or dissolved in a liquid as well as pastes. In one embodiment, its viscosity is in the range 3500 - 10000 (3.5 - 10 Pa·s), preferably in the range 5000 - 10000 cP (5 - 10 Pa·s).

The conductive materials can take a variety of forms, including particles, powders, flakes and foils. Examples of metals include silver, copper, aluminum, platinum, palladium, nickel, chromium, gold, bronze, colloidal metals, and other highly conductive metals.

In some embodiments, an average particle size within a range of 0.05 - 100 µm, and especially 0.1 - 10 µm, is preferred. The metal powder may have any suitable particle shape, including granular, dendritic or flake-like, or may be of irregular shape. Alternatively, a mixture of metal powders having a combination of these shapes may be used.

In some embodiments, the conducting material may include carbon nanotubes, graphene or other conductive organic materials. In addition, in some embodiments the conducting material may have isotropic particle shape.

Further, in an example embodiment of the formulation, the weight percent of the conductive filler is in the range of 5% - 15%, preferably in the range of 10% - 12% based on the total weight of the mass of the formulation.

Conductive properties may be improved by mixing different geometry of a similar filler type. In one embodiment, the mixing of silver particles in a spherical shape was made with flakes shape in a ratio of 20:1 weight ratio.

The viscosity of conductive ink 110 may be in the range of 3500 - 10000 cP, preferably in the range of 5000 - 10000 cP. To obtain the desired viscosity, plasticizer is added. For example, hexamethylcyclotrisiloxane, tetramethylcyclotetrasiloxane and preferably polydimethylsiloxane may be added to the ink 110. In some embodiments, the conductive ink 110 may have a degradation temperature of greater than 280 °C.

Embodiments of the formulation can optionally contain adhesion promoters to facilitate interfacial adhesion between the conductive ink with the substrate. The adhesion promoter contains bipolar head-group with a long hydrophobic alkyl chain connecting the two ends. Examples of such molecules include glycidyloxypropyltrimethoxysilane and amino-terminated tripropyl tetraethoxysilane. In some embodiments, other polar molecules where one end is polar, the other end is non-polar may be utilized. In one embodiment, the amount of adhesion promoters is added into the formulation in the range of 0.1% - 10% weight percent, preferably in the range of 0.1% to 5% weight percent of the total mass of the formulation.

There are two mechanisms of polysiloxane fabrication, addition 200 and condensation 210. The addition mechanism 200 and the condensation mechanism 210 are differentiated based on the mechanism of crosslink network formation.

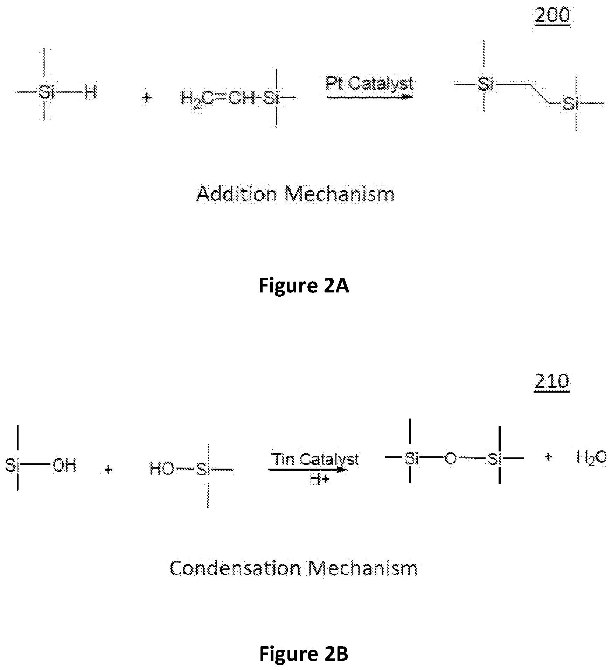

In the addition mechanism 200, also known as hydrosilylation, a transition metal catalyst (e.g. Platinum or Rhodium) is used to affect reaction between Si-H and a vinyl functional group. The addition mechanism 200 forms new Si-C bond (carbosilane). The addition mechanism is schematically depicted in Figure 2A.

In the condensation mechanism 210, a tin catalyst with a trace amount of an acid is used to catalyze the formation of linkage between two hydroxyl or alkoxyl groups. This reaction mechanism is generally utilized by those familiar in the art prior to the present invention. This reaction also triggers the release of byproducts. The condensation mechanism 210 forms new Si-O bonds that are polarized and susceptible to further hydrolysis. The condensation mechanism 210 is schematically depicted in Figure 2B.

The condensation mechanism 210 undergoes a post-curing stage once it has been thermally initiated. Inducement of a post-curing reaction ensures optimization of crosslink density. A material with a high level of crosslink density displays improved thermal and mechanical properties. Nevertheless, the process itself could induce the chances of settling or blooming of conductive particulates or other additives as these fillers might be segregated out from the binder phase during the process of network formation. Within the period of post curing, the conductive particulate is still immobilized and freely moved about the matrix affecting inhomogeneity distribution. This may result in a common phenomenon whereby a conductive ink displays deteriorating properties within a short period of duration when adopting purely condensation type of curing.

Examples of post curing performed on reacted product include 10 hours at 80 °C, preferably 5 hours at 80°C, and most preferably at 3 hours at 80 °C.

The advantage of the addition mechanism 200 is that the reaction proceeds at a faster rate and does not produce low-molecular weight by-products. [ref: Polymer Degradation and Stability, (2011), 96, 2064 - 2070]. Further, curing reaction is terminated once the reactive Si-H or vinyl group has been used up. These affect the establishment of a rigid crosslink network in a shorter time which induces immobilization of any filler or additives present in the system. The chances of the effect of blooming or settling of these additives and the particulates is overcome with an increase in rate of crosslink formation. Arguably, addition mechanism results in crosslink network of reduced shrinkage effect.

Embodiments of the present invention utilize both the addition mechanism 200 and the condensation mechanism 210 to form the stretchable conductive circuit package 100.

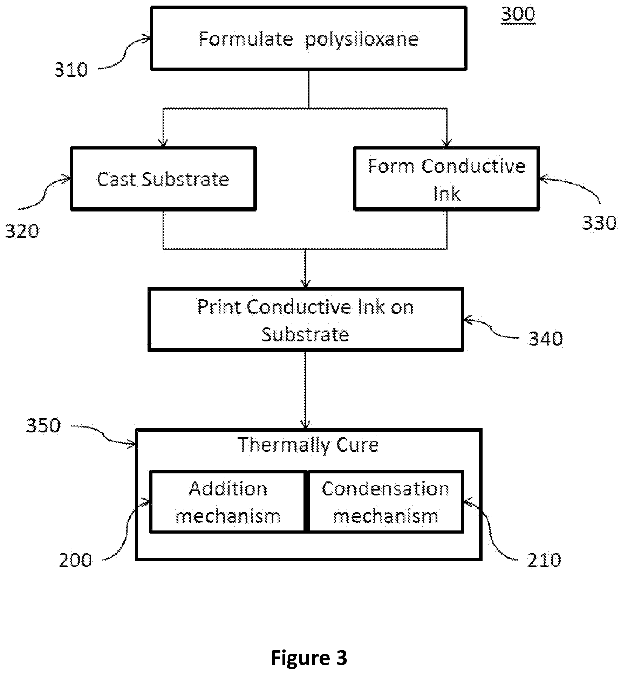

Figure 3 is a process map of the process 300 that fabricates stretchable conductive circuit package 100. In step 310, the polysiloxane material is formulated. In accordance with an embodiment of the invention, the basic ingredients for both substrate and the conductive ink are hydroxyl or alkoxyl-terminated polysiloxane. In the case of the conductive ink, additional vinyl terminated PDMS is added to affect addition reaction. In some embodiments, an adhesion promoter such as (3-glycidyloxypropyl)trimethoxysilane or aminopropyl triethoxysilane may be introduced. This other adhesion promoter may be used which contains both hydrophilic terminated end and bridging hydrophobic segment. The use of an adhesion promoter ensures sufficient adhesion between the conductive ink 110 and the substrate 120 via strong chemical forces.

Then, in step 320, the substrate 120 is cast using the polysiloxane material formulated in step 310. The substrate 120 may be allowed to cure at ambient temperature for 24 hours but preferably 5 hours, and more preferably 3 hours. In many embodiments, the curing of the substrate 120 may utilize a condensation mechanism 200. Post curing is performed where the substrate 120 is annealed at 80 °C for 24 hours.

In step 330, a conducting material is added to the polysiloxane material formulated in step 310 to form the conductive ink 110. The same basic polysiloxane material is used in forming the matrix of conductive ink as the substrate to ensure the materials have similar Young's modulus and sufficient interfacial compatibility. For example, the conductive ink may be in the range of 0.4 to 2.0 ohm with maximum stretchability of 70%.

Next, in step 340 the conductive ink made in step 330 is printed on the substrate cast in step 320. The inks may be applied to the substrate using any suitable method familiar to the prior art, including, but not limited to, painting, pouring, spin casting, solution casting, dip coating, powder coating, by syringe or pipette, spray coating, curtain coating, lamination, co-extrusion, electrospray deposition, ink-jet printing, spin coating, thermal transfer (including laser transfer) methods, doctor blade printing, screen printing, rotary screen printing, gravure printing, capillary printing, offset printing, flexographic printing, pad printing, stamping, xerography, microcontact printing, dip pen nanolithography, laser printing, via pen or similar means, etc.

When applied to a substrate, the inks can have a variety of forms. They can be present as a film or lines, patterns, circuitry, and other shapes.

When applied to a substrate, the ink can preferably have a thickness of at least about 0.01mm, or more preferably at least about 0.5 mm. In various embodiments of the invention, the coatings can have a width of about 0.1 mm to 2 mm, and preferably of about 0.01 mm to 1 mm,

In some embodiments, after the ink is printed, additional electronic components are mounted onto conductive ink 110 prior to curing. The electronic components may include transistors, diodes, capacitors, or other known electrical components. When the electronic components are mounted onto the conductive ink 110, the conductive ink 110 electrically connects the components to form an electrical circuit. Collectively, these electronic components may form device modules such as sensors and actuators.

Finally in step 350, a circuit pattern is thermally cured to the substrate. The thermal curing process includes both the addition mechanism 200 and the condensation mechanism 210. Curing time is from approximately 5 hours to 24 hours, preferably approximately 8 hours to 10 hours, while the temperature is in the range of 40°C to 200 °C, preferably between 80°C to 100°C. The addition mechanism 200 and the condensation mechanism 210 are performed concurrently. At elevated temperature, both mechanisms start to cure. For both mechanisms, a minimum temperature of 40°C is required, however it should be noted that curing time may be prolonged at this minimum temperature.

By employing the addition curing mechanism 210, the conductive ink 110 does not display any significant shrinkage due to the rigid crosslink network. Further, blooming or settling of conductive material are limited because the conductive material is tightly trapped in between the cross-linkages. To this effect, no coupling agent or coating layer need be applied on these particulate surfaces to improve dispersion in the polymeric binder. Crosslink density resulting from curing using the condensation mechanism 210 is significantly increased due to the multi-functionality of the curing agent. The synergetic effect from the addition and condensation curing system contribute to the thermal stability and filler dispersion in the ink.

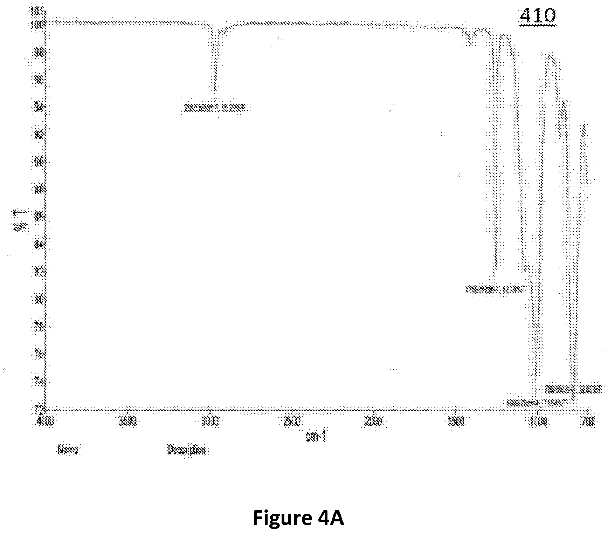

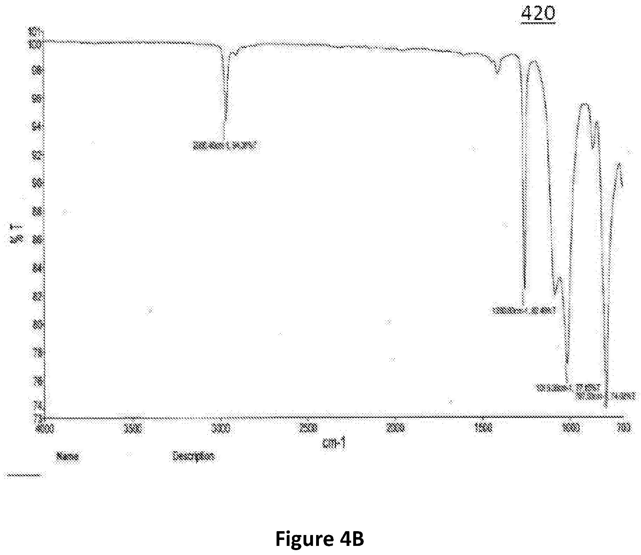

Figure 4A depicts the Fourier-transform infrared spectroscopy (FTIR) 410 of the substrate 120. Figure 4B depicts the FTIR 420 of the conductive ink 120. The FTIR 410 for the substrate 120 and the FTIR 420 of the conductive ink 110 display almost similar peaks patterns. However, there is a slight shoulder peak occurring at ~ 900 cm-1 in the FTIR 420. This shoulder peak represents the silver particle bounded in the binder matrix.

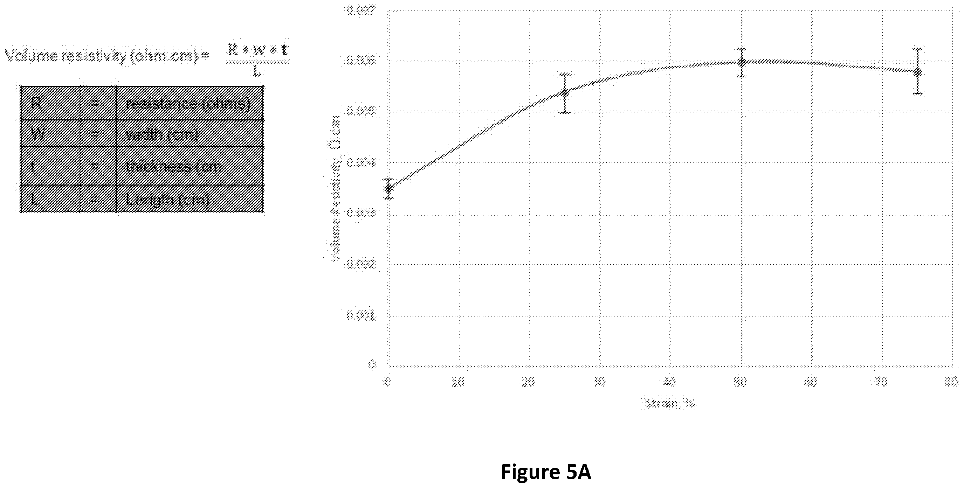

The term "volume resistivity" as the term applied here means a value of electrical resistance expressed in a unit volume (1 cm×1 cm×1 cm), as ρv (ohm-cm). This value is usually obtained by measuring the potential difference (V) between two electrodes separated in a distance (L) when a constant current (I) flows through a cross-sectional area (A); where ρv=(V/I)(A/L) as referenced in Loresta-G P, Instruction Manual for Low Resistivity Meter (Mitsubishi Chemical Corporation). The volume resistivity as a function of applied strain of the resulting stretchable conductive circuit package 100 is depicted in Figure 5A. In some embodiments, it may have a volume resistivity without stretch of 0.0035 SZcm which increases to 0.0054 Qcm at 25% and then plateaus. The initial increase in volume resistivity is mainly attributed to the poor connectivity between the conductive particles during stretching. At higher strain, dis-connectivity is almost complete resulting in no further changes in the volume resistance.

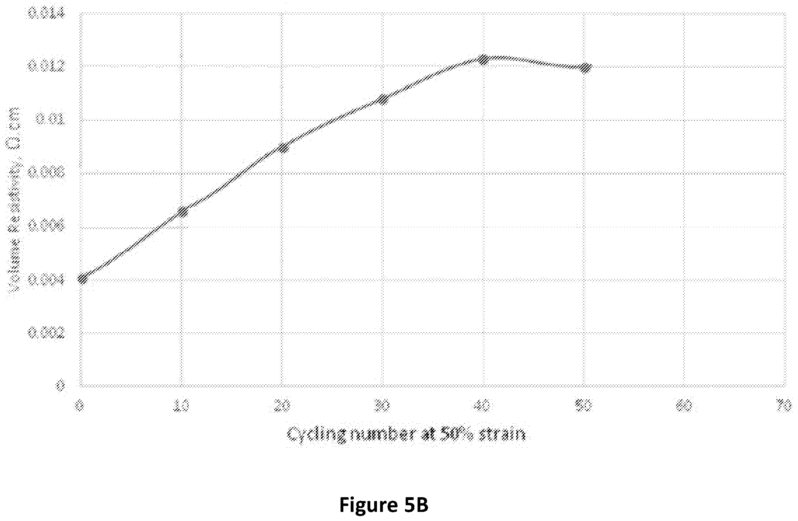

Figure 5B depicts resistivity as a function of strain cycle number. In some embodiments at 50% strain, the volume resistivity is initially 0.0045 SZcm and increase almost proportionally with fatigue strain of at least 60 cycles. During fatigue strain, the conductive particles gradually separated from each other which reduced any conductive connectivity.

Applications of this circuitry include, but are not limited to, passive and active devices and components; electrical and electronic circuitry, integrated circuits; flexible printed circuit boards; transistors; field-effect transistors; microelectromechanical systems (MEMS) devices; microwave circuits; antennas; diffraction gratings; indicators; chip less tags (e.g. for theft deterrence from stores, libraries, etc.); smart cards; sensors; liquid crystalline displays (LCDs); signage; lighting; flat panel displays; flexible displays, including light-emitting diode, organic light-emitting diode, and polymer lighting diode displays; backplanes and frontplanes for displays; electroluminescent and OLED lighting; photovoltaic devices, including backplanes; product identifying chips and devices; batteries, including thin film batteries; electrodes; indicators; printed circuits in portable electronic devices (for example, cellular telephones, computers, personal digital assistants, global positioning system devices, music players, games, calculators, etc.); electronic connections made through hinges or other movable/bendable junctions in electronic devices such as cellular telephones, portable computers, folding keyboards, etc.); wearable electronics; and circuits in vehicles, medical devices, diagnostic devices, instruments, etc.

It is to be understood that the present invention is not limited to the embodiments described above, but encompasses any and all embodiments within the scope of the following claims.

## Claims

1. A method for forming a flexible printed circuit board, the method comprising:
formulating a polysiloxane material including a hydroxyl- or alkoxyl-terminated polysiloxane as a basic ingredient;
casting a first portion of the polysiloxane material into a substrate;
adding a vinyl-terminated polydimethylsiloxane, PDMS, a liquid organohydrogensiloxane PDMS, and a conductive material to a second portion of the polysiloxane material to form a conductive ink;
depositing the conductive ink on the substrate to form at least one electrical circuit; and
thermally curing the conductive ink to the substrate at a minimum temperature of 40°C by substantially simultaneously using an addition mechanism and a condensation mechanism.

2. The method of claim 1, wherein the conductive ink contains
the liquid vinyl-terminated PDMS, and
wherein the liquid organohydrogensiloxane PDMS is a liquid organohydrogensiloxane PDMS having an average of at least a silicon-bonded hydrogen atoms per molecule and consisting essentially of units selected from the group consisting of methylhydrogensiloxy, dimethylsiloxy, dimethylhydrogensiloxy and trimethylsiloxy, wherein an amount of the organohydrogensiloxane PDMS is sufficient to provide a silicon-bonded hydrogen atom per vinyl group present in vinyl-terminated PDMS.

3. The method of any one of the preceding claims, wherein the conductive ink and the formulation for forming the substrate include a hydroxyl-terminated polydimethylsiloxane as the basic ingredient.

4. The method of claim 3, wherein the formulation for forming the substrate includes 50wt.% to 95wt.% of liquid hydroxyl-terminated PDMS based on the total weight of the substrate formulation; and/or
the conductive ink includes 5wt.% to 30wt.% of liquid hydroxyl-terminated PDMS based on the total weight of the ink formulation.

5. The method of claim 2, wherein the addition mechanism is a hydrosilylation reaction between the liquid vinyl-terminated PDMS and the liquid organohydrogensiloxane PDMS in the presence of a transition metal catalyst.

6. The method of claim 5, wherein the transition metal catalyst is platinum or rhodium.

7. The method of claim 3, wherein the condensation mechanism is a condensation reaction between hydroxyl groups of the hydroxyl-terminated PDMS in the presence of a tin catalyst.

8. The method of claim 1, wherein the formulating the polysiloxane material includes adding an adhesion promoter, in particular (3-glycidyloxypropyl)trimethoxysilane.

9. The method of claim 1, wherein the conductive material of the conductive ink is a metal powder.

10. The method of claim 9, wherein the metal powder includes at least one of silver, gold, nickel and copper.

11. The method of claim 3, wherein the hydroxyl-terminated polydimethylsiloxane has a molecular weight in a range of 100,000 to 120,000 g/mol.

12. The method of claim 1, wherein a viscosity of the conductive ink is in a range of 3.5 - 10 Pas.

13. The method of claim 1, wherein the formulating the polysiloxane material includes adding a plasticizer, in particular hexamethylcyclotrisiloxane, tetramethylcyclotetrasiloxane or polydimethylsiloxane.

14. A flexible printed circuit board formed according to the method of claim 1.

## Patentansprüche

1. Verfahren zum Ausbilden einer flexiblen Leiterplatte, wobei das Verfahren umfasst:
Formulieren eines Polysiloxanmaterials, das ein hydroxyl- oder alkoxylterminiertes Polysiloxan als Grundbestandteil enthält;
Gießen eines ersten Teils des Polysiloxanmaterials in ein Substrat;
Hinzufügen eines vinylterminierten Polydimethylsiloxans, PDMS, eines flüssigen Organohydrogensiloxan-PDMS, und eines leitfähigen Materials zu einem zweiten Teil des Polysiloxanmaterials, um eine leitfähige Tinte zu bilden;
Ablagern der leitfähigen Tinte auf dem Substrat, um mindestens eine elektrische Schaltung auszubilden; und
thermisches Aushärten der leitfähigen Tinte auf dem Substrat bei einer Mindesttemperatur von 40°C durch im Wesentlichen gleichzeitige Verwendung eines Additionsmechanismus und eines Kondensationsmechanismus.

2. Verfahren nach Anspruch 1, wobei die leitfähige Tinte Folgendes enthält
das flüssige, vinylterminierte PDMS, und
wobei das flüssige Organohydrogensiloxan-PDMS ein flüssiges Organohydrogensiloxan-PDMS ist, das einen Durchschnitt von mindestens einem siliciumgebundenen Wasserstoffatom pro Molekül aufweist und im Wesentlichen aus Einheiten besteht, die aus der Gruppe ausgewählt sind, die aus Methylhydrogensiloxy, Dimethylsiloxy, Dimethylhydrogensiloxy und Trimethylsiloxy besteht, wobei eine Menge des Organohydrogensiloxan-PDMS ausreicht, um ein siliciumgebundenes Wasserstoffatom pro Vinylgruppe bereitzustellen, die in vinylterminiertem PDMS vorhanden ist.

3. Verfahren nach einem der vorhergehenden Ansprüche, wobei die leitfähige Tinte und die Formulierung zur Ausbildung des Substrats ein hydroxylterminiertes Polydimethylsiloxan als Grundbestandteil enthalten.

4. Verfahren nach Anspruch 3, wobei die Formulierung zur Bildung des Substrats 50 Gew.-% bis 95 Gew.-% flüssiges hydroxylterminiertes PDMS, bezogen auf das Gesamtgewicht der Substratformulierung, enthält; und/oder
die leitfähige Tinte 5 Gew.-% bis 30 Gew.-% flüssiges hydroxylterminiertes PDMS, bezogen auf das Gesamtgewicht der Tintenformulierung, enthält.

5. Verfahren nach Anspruch 2, wobei der Additionsmechanismus eine Hydrosilylierungsreaktion zwischen dem flüssigen vinylterminierten PDMS und dem flüssigen Organohydrogensiloxan-PDMS in Gegenwart eines Übergangsmetallkatalysators ist.

6. Verfahren nach Anspruch 5, wobei der Übergangsmetallkatalysator Platin oder Rhodium ist.

7. Verfahren nach Anspruch 3, wobei der Kondensationsmechanismus eine Kondensationsreaktion zwischen Hydroxylgruppen des hydroxylterminierten PDMS in Gegenwart eines Zinnkatalysators ist.

8. Verfahren nach Anspruch 1, wobei die Formulierung des Polysiloxanmaterials die Zugabe eines Haftvermittlers, insbesondere von (3-Glycidyloxypropyl)trimethoxysilan, umfasst.

9. Verfahren nach Anspruch 1, wobei das leitfähige Material der leitfähigen Tinte ein Metallpulver ist.

10. Verfahren nach Anspruch 9, wobei das Metallpulver mindestens eines von Silber, Gold, Nickel und Kupfer enthält.

11. Verfahren nach Anspruch 3, wobei das hydroxylterminierte Polydimethylsiloxan ein Molekulargewicht im Bereich von 100.000 bis 120.000 g/mol aufweist.

12. Verfahren nach Anspruch 1, wobei die Viskosität der leitfähigen Tinte in einem Bereich von 3,5 - 10 Pa s liegt.

13. Verfahren nach Anspruch 1, wobei die Formulierung des Polysiloxanmaterials die Zugabe eines Weichmachers, insbesondere Hexamethylcyclotrisiloxan, Tetramethylcyclotetrasiloxan oder Polydimethylsiloxan, umfasst.

14. Flexible Leiterplatte, ausgebildet nach dem Verfahren gemäß Anspruch 1.

## Revendications

1. Procédé pour former une carte de circuit imprimé flexible, le procédé comprenant :
former un matériau polysiloxanique comprenant un polysiloxane à terminaison hydroxyle ou alcoxyle comme ingrédient de base ;
couler une première partie du matériau polysiloxane dans un substrat ;
ajouter un polydiméthylsiloxane à terminaison vinyle, PDMS, un PDMS organohydrogensiloxane liquide, et un matériau conducteur à une deuxième partie du matériau polysiloxane pour former une encre conductrice ;
déposer l'encre conductrice sur le substrat pour former au moins un circuit électrique ; et
durcir thermiquement l'encre conductrice sur le substrat à une température minimale de 40°C en utilisant essentiellement simultanément un mécanisme d'addition et un mécanisme de condensation.

2. Procédé de la revendication 1, dans lequel l'encre conductrice contient
le PDMS liquide à terminaison vinyle, et
dans lequel le PDMS organohydrogensiloxane liquide est un PDMS organohydrogensiloxane liquide ayant en moyenne au moins un atome d'hydrogène lié au silicium par molécule et constitué essentiellement d'unités choisies dans le groupe constitué de méthylhydrogensiloxy, diméthylsiloxy, diméthylhydrogensiloxy et triméthylsiloxy, dans lequel une quantité de PDMS organohydrogensiloxane est suffisante pour fournir un atome d'hydrogène lié au silicium par groupe vinyle présent dans le PDMS à terminaison vinyle.

3. Procédé de l'une quelconque des revendications précédentes, dans lequel l'encre conductrice et la formulation pour former le substrat comprennent un polydiméthylsiloxane à terminaison hydroxyle comme ingrédient de base.

4. Procédé selon la revendication 3, dans lequel la formulation pour former le substrat comprend 50 % en poids à 95 % en poids de PDMS liquide à terminaison hydroxyle, par rapport au poids total de la formulation du substrat ; et/ou
l'encre conductrice contient de 5 à 30 % en poids de PDMS liquide à terminaison hydroxyle par rapport au poids total de la formulation de l'encre.

5. Procédé selon la revendication 2, dans lequel le mécanisme d'addition est une réaction d'hydrosilylation entre le PDMS liquide à terminaison vinyle et l'organohydrogensiloxane PDMS liquide en présence d'un catalyseur à base de métal de transition.

6. Procédé de la revendication 5, dans lequel le catalyseur à base de métal de transition est du platine ou du rhodium.

7. Procédé selon la revendication 3, dans lequel le mécanisme de condensation est une réaction de condensation entre les groupes hydroxyles du PDMS à terminaison hydroxyle en présence d'un catalyseur à base d'étain.

8. Procédé selon la revendication 1, dans lequel la formulation du matériau polysiloxane comprend l'ajout d'un promoteur d'adhésion, en particulier le (3-glycidyloxypropyl)triméthoxysilane.

9. Procédé de la revendication 1, dans lequel le matériau conducteur de l'encre conductrice est une poudre métallique.

10. Procédé de la revendication 9, dans lequel la poudre métallique comprend au moins l'un d'argent, d'or, de nickel et de cuivre.

11. Procédé selon la revendication 3, dans lequel le polydiméthylsiloxane à terminaison hydroxyle a un poids moléculaire compris entre 100 000 et 120 000 g/mol.

12. Procédé de la revendication 1, dans lequel la viscosité de l'encre conductrice est comprise entre 3,5 et 10 Pa s.

13. Procédé selon la revendication 1, dans lequel la formulation du matériau polysiloxane comprend l'ajout d'un plastifiant, en particulier l'hexaméthylcyclotrisiloxane, le tétraméthylcyclotétrasiloxane ou le p olydiméthylsiloxane.

14. Carte de circuit imprimé flexible formée selon le procédé de la revendication 1.
